(19) 

**Europäisches Patentamt**
**European Patent Office**
**Office européen des brevets**

(11) **EP 4 425 198 B1**

(12) **EUROPEAN PATENT SPECIFICATION**

(45) Date of publication and mention
of the grant of the patent:
**12.11.2025 Bulletin 2025/46**

(21) Application number: **22919057.4**

(22) Date of filing: **19.12.2022**

(51) International Patent Classification (IPC):
**G01R 31/367** (2019.01)   **G01R 31/382** (2019.01)
**G01R 19/00** (2006.01)   **G01R 31/396** (2019.01)
**G01R 31/387** (2019.01)   **G01R 31/392** (2019.01)
**G01R 31/374** (2019.01)

(52) Cooperative Patent Classification (CPC):
**G01R 31/392; G01R 31/367; G01R 31/374;**
**G01R 31/387; Y02E 60/10**

(86) International application number:
**PCT/KR2022/020745**

(87) International publication number:
**WO 2023/132520 (13.07.2023 Gazette 2023/28)**

(54) **BATTERY CAPACITY PREDICTION APPARATUS AND OPERATING METHOD THEREOF**

BATTERIEKAPAZITÄTSVORHERSAGEVORRICHTUNG UND BETRIEBSVERFAHREN DAFÜR

BATTERY CAPACITY PREDICTION DEVICE AND OPERATION METHOD THEREOF

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **07.01.2022 KR 20220003018**

(43) Date of publication of application:
**04.09.2024 Bulletin 2024/36**

(73) Proprietor: **LG Energy Solution, Ltd.**
**Seoul 07335 (KR)**

(72) Inventor: **CHOI, Jung Hwan**
**Daejeon 34122 (KR)**

(74) Representative: **Plasseraud IP**
**104 Rue de Richelieu**
**CS92104**
**75080 Paris Cedex 02 (FR)**

(56) References cited:
**CN-A- 113 030 760      JP-B2- 6 380 417**
**KR-A- 20140 056 693    KR-A- 20160 067 559**
**KR-A- 20200 140 093    US-A1- 2014 333 313**
**US-A1- 2017 082 694    US-A1- 2019 227 127**
**US-A1- 2020 011 932    US-A1- 2020 284 846**

**US-A1- 2020 386 819    US-A1- 2021 215 770**
**US-B2- 9 429 628**

- SCHIMPE MICHAEL ET AL: "Battery
  Degradation-Aware Current Derating: An
  Effective Method to Prolong Lifetime and Ease
  Thermal Management", JOURNAL OF THE
  ELECTROCHEMICAL SOCIETY, vol. 168, no. 6, 14
  June 2021 (2021-06-14), pages 1 - 13,
  XP093021162, ISSN: 0013-4651, DOI: 10.1149/
  1945-7111/ac0553
- CHEN ZHENG ET AL: "Capacity Prediction and
  Validation of Lithium-Ion Batteries Based on
  Long Short-Term Memory Recurrent Neural
  Network", IEEE ACCESS, IEEE, USA, vol. 8, 21
  September 2020 (2020-09-21), pages 172783 -
  172798, XP011811848, DOI: 10.1109/
  ACCESS.2020.3025766
- SCHIMPE MICHAEL, BARRERAS JORGE V., WU
  BILLY, OFFER GREGORY J.: "Battery
  Degradation-Aware Current Derating: An
  Effective Method to Prolong Lifetime and Ease
  Thermal Management", JOURNAL OF THE
  ELECTROCHEMICAL SOCIETY,
  ELECTROCHEMICAL SOCIETY., vol. 168, no. 6,
  14 June 2021 (2021-06-14), pages 1 - 13,
  XP093021162, ISSN: 0013-4651, DOI: 10.1149/
  1945-7111/ac0553

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 425 198 B1

**Description**

**[TECHNICAL FIELD]**

CROSS-REFERENCE TO RELATED APPLICATION

This application claims priority to and the benefit of Korean Patent Application No. 10-2022-0003018 filed in the Korean Intellectual Property Office on January 7, 2022.

TECHNICAL FIELD

The present invention relates to a battery capacity prediction apparatus and an operating method thereof.

**[BACKGROUND ART]**

An electric vehicle is supplied with electricity from outside to charge a battery cell, and then a motor is driven by a voltage charged in the battery cell to obtain power. The battery cell of the electric vehicle may have heat generated therein by chemical reaction occurring in a process of charging and discharging electricity, and the heat may impair performance and lifetime of the battery cell.

As battery cells are repeatedly used and charged and discharged, they age, their lives are gradually shortened, and their capacities decrease. The decrease in a capacity of a battery cell may vary depending on use temperature, charge current, discharge current, and discharge depth of the battery cell, and the capacity of the battery cell may rapidly decrease depending on the decreasing amount of a positive electrode material or a negative electrode material and lithium ions inside the battery cell. When the capacity of a battery cell rapidly decreases, it may lead to a decrease in available battery energy, which reduces the effectiveness of a battery and deteriorates the stability of the battery.

Document US 2020/0386819 discloses a system and method of predicting variations in a capacity of a battery

**[DISCLOSURE]**

**[TECHNICAL PROBLEM]**

Embodiments disclosed herein aim to provide a battery capacity prediction apparatus and an operating method thereof in which a decrease in a capacity of a battery in various temperature, current, and voltage sections may be analyzed to diagnose a rapid capacity decrease of the battery in advance.

Technical problems of the embodiments disclosed herein are not limited to the above-described technical problems, and other unmentioned technical problems would be clearly understood by one of ordinary skill in the art from the following description.

**[TECHNICAL SOLUTION]**

The present invention is directed to a battery capacity prediction apparatus according to claim 1.

The present invention is also directed to an operating method of a battery capacity prediction apparatus according to claim 6. Embodiments of the invention are defined in the dependent claims.

**[ADVANTAGEOUS EFFECTS]**

With a battery capacity prediction apparatus and an operating method thereof according to an embodiment disclosed herein, a capacity decrease of a battery in various temperature, current, and voltage sections may be analyzed to diagnose a rapid capacity decrease of the battery in advance.

**[DESCRIPTION OF DRAWINGS]**

FIG. 1 illustrates a battery pack according to an embodiment disclosed herein.
FIG. 2 is a block diagram showing a configuration of a battery capacity prediction apparatus, according to an embodiment disclosed herein.
FIG. 3 is a graph showing capacity data change of a battery and reference capacity data change with respect to cycle change of the battery, according to an embodiment disclosed herein.

FIG. 4A is a graph showing comparison value change with respect to temperature change of a battery, according to an embodiment disclosed herein.

FIG. 4B is a graph showing comparison value change with respect to current change of a battery, according to an embodiment disclosed herein.

FIG. 5 is a graph showing change in capacity deterioration amount per cycle of a battery with respect to cycle change of the battery, according to an embodiment disclosed herein.

FIG. 6A is a graph showing a capacity change pattern of a battery with respect to a full equivalent cycle change of the battery, according to an embodiment disclosed herein.

FIG. 6B is a graph showing a capacity change of a battery with respect to a full equivalent cycle change of the battery, according to an embodiment disclosed herein.

FIG. 7 is a flowchart of an operating method of a battery capacity prediction apparatus according to an embodiment disclosed herein.

FIG. 8 is a block diagram showing a hardware configuration of a computing system for implementing a battery capacity prediction apparatus according to an embodiment disclosed herein.

[MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

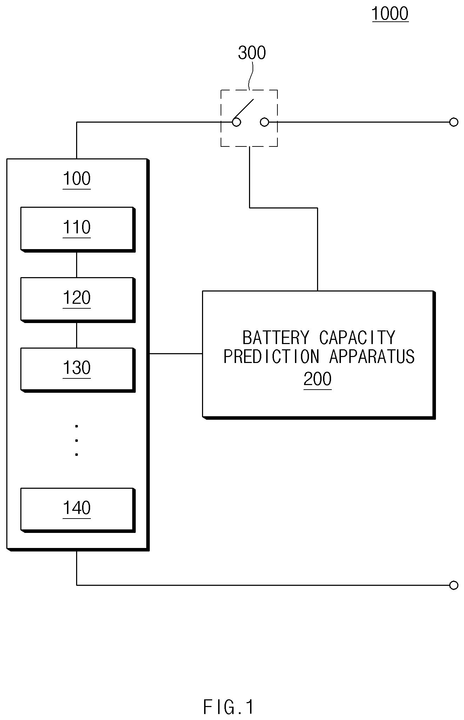

FIG. 1 illustrates a battery pack according to an embodiment disclosed herein.

Referring to FIG. 1, a battery pack 1000 according to an embodiment disclosed herein may include a battery module 100, a battery capacity prediction apparatus 200, and a relay 300.

The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery capacity prediction apparatus 200 may predict a capacity of the plurality of battery cells 110, 120, 130, and 140 based on temperature, current, and voltage data of the plurality of battery cells 110, 120, 130, and 140. The battery capacity prediction apparatus 200 may predict the capacity of the plurality of battery cells 110, 120, 130, and 140 for each of temperature, current, and voltage of a battery based on battery data of the plurality of battery cells 110, 120, 130, and 140.

According to an embodiment, the battery capacity prediction apparatus 200 may be implemented in the form of a battery management system (BMS). Moreover, according to an embodiment, the battery capacity prediction apparatus 200 may be mounted on a battery management system.

Herein, the battery management system may manage and/or control a state and/or an operation of the battery module 100. For example, the battery management system may manage and/or control the states and/or operations of the plurality of battery cells 110, 120, 130, and 140 included in the battery module 100. The battery management system may manage charge and/or discharge of the battery module 100.

In addition, the battery management system may monitor voltage, current, temperature, etc., of the battery module 100 and/or each of the plurality of battery cells 110, 120, 130, and 140 included in the battery module 100. A sensor or various measurement modules for monitoring performed by the battery management system, which are not shown, may be additionally installed in the battery module 100, a charging/discharging path, any position of the battery module 100, etc. The battery management system may calculate a parameter indicating a state of the battery module 100, e.g., a state of charge (SoC), a state of health (SoH) etc., based on a measurement value such as monitored voltage, current, temperature, etc.

The battery management system may control an operation of the relay 300. For example, the battery management system may short-circuit the relay 300 to supply power to the target device. The battery management system may short-circuit the relay 300 when a charging device is connected to the battery pack 1000.

The battery management system may calculate a cell balancing time of each of the plurality of battery cells 110, 120, 130, and 140. Herein, the cell balancing time may be defined as a time required for balancing of the battery cell. For example, the battery management system may calculate a cell balancing time based on an SoC, a battery capacity, and a balancing efficiency of each of the plurality of battery cells 110, 120, 130, and 140.

Hereinbelow, a configuration and an operation of the battery capacity prediction apparatus 200 will be described in detail.

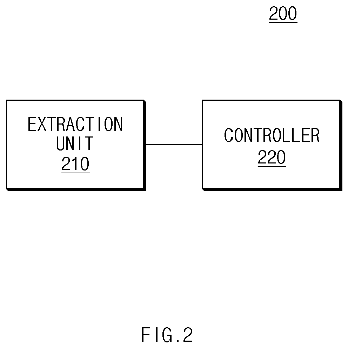

FIG. 2 is a block diagram showing a configuration of a battery capacity prediction apparatus, according to an embodiment disclosed herein.

Hereinbelow, a configuration of the battery capacity prediction apparatus 200 will be described with reference to FIG. 2.

First, referring to FIG. 2, the battery capacity prediction apparatus 200 may include an extraction unit 210 and a controller 220.

The extraction unit 210 may obtain capacity data C obtained by measuring the capacity of the plurality of battery cells 110, 120, 130, and 140.

The extraction unit 210 may obtain reference capacity data ($C_{RPT}$) obtained by measuring a reference capacity of the plurality of battery cells 110, 120, 130, and 140. Herein, a reference capacity may refer to a capacity of a battery, measured through a reference performance test (RPT). The reference performance test may periodically measure a life or a capacity of a battery under specific temperature, specific current, and specific voltage range conditions to identify deteriorating performance of the target device. According to an embodiment, the reference performance test may repeat charge and discharge under specific temperature and specific current conditions until the battery reaches a voltage with an SoC of 100 % from a voltage with an SoC of 0 %.

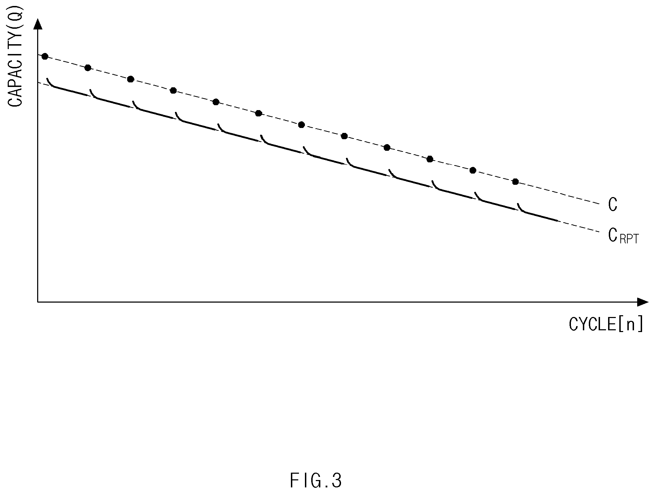

FIG. 3 is a graph showing capacity data change of a battery and reference capacity data change with respect to cycle change of the battery, according to an embodiment disclosed herein. Referring to FIG. 3, the extraction unit 210 may compare reference capacity data ($C_{RPT}$) of the plurality of battery cells 110, 120, 130, and 140 with measured capacity data C of the plurality of battery cells 110, 120, 130, and 140 to extract comparison data of comparing a measured capacity C of the plurality of battery cells 110, 120, 130, and 140 with a reference capacity ($C_{RPT}$) of the plurality of battery cells 110, 120, 130, and 140. More specifically, the extraction unit 210 may extract a comparison value ( $\frac{C}{C_{RPT}}$ ) of comparing the measured capacity C of the plurality of battery cells 110, 120, 130, and 140 with the reference capacity ($C_{RPT}$) of the plurality of battery cells 110, 120, 130, and 140.

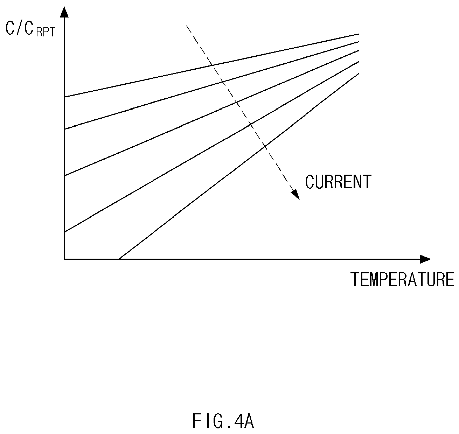

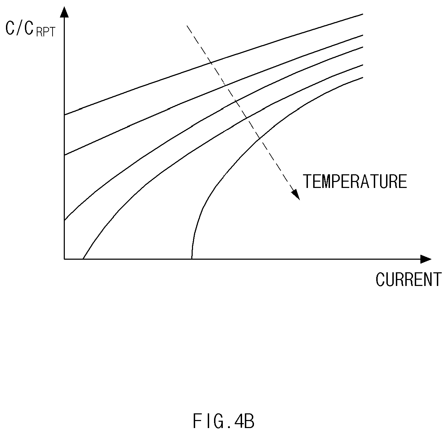

FIG. 4A is a graph showing comparison value change with respect to temperature change of a battery, according to an embodiment disclosed herein. FIG. 4B is a graph showing comparison value change with respect to current change of a battery, according to an embodiment disclosed herein.

Referring to FIGS. 4A and 4B, the extraction unit 210 may generate a graph showing comparison value change with respect to temperature change of the plurality of battery cells 110, 120, 130, and 140. The extraction unit 210 may generate a graph showing change in comparison value ( $\frac{C}{C_{RPT}}$ ) with respect to current of the plurality of battery cells 110, 120, 130, and 140. The extraction unit 210 may analyze change in comparison value ( $\frac{C}{C_{RPT}}$ ) with respect to temperature change of the plurality of battery cells 110, 120, 130, and 140 or current change of the plurality of battery cells 110, 120, 130, and 140 to measure a trend of change in comparison value ( $\frac{C}{C_{RPT}}$ ) with respect to temperature change of the plurality of battery cells 110, 120, 130, and 140 or a trend of change in comparison value ( $\frac{C}{C_{RPT}}$ ) with respect to current change of the battery.

The extraction unit 210 may measure a capacity change amount per cycle of the plurality of battery cells 110, 120, 130, and 140 with respect to cycle change of the plurality of battery cells 110, 120, 130, and 140. That is, the extraction unit 210 may measure a capacity deterioration amount per cycle ($\Delta C$) of the plurality of battery cells 110, 120, 130, and 140 with respect to cycle change of the plurality of battery cells 110, 120, 130, and 140.

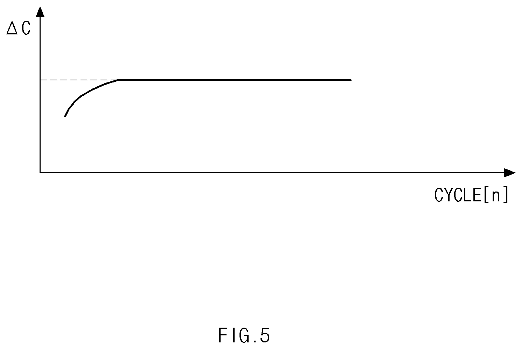

FIG. 5 is a graph showing change in capacity deterioration amount per cycle of a battery with respect to cycle change of the battery, according to an embodiment disclosed herein. Referring to FIG. 5, the extraction unit 210 may extract capacity change data obtained by measuring a capacity change per cycle of a battery with respect to cycle change of the plurality of battery cells 110, 120, 130, and 140. For example, when a capacity for n cycle repetitions of the plurality of battery cells 110, 120, 130, and 140 is defined as $C_n$, and a capacity of the plurality of battery cells 110, 120, 130, and 140 before k cycles is defined as $C_{n-k}$, a capacity deterioration amount defined per cycle $\Delta C = C_n - C_{n-k}$ of the plurality of battery cells 110, 120, 130, and 140 may be calculated.

The extraction unit 210 may extract capacity change data indicating change in capacity deterioration amount per cycle ($C_n$) of the plurality of battery cells 110, 120, 130, and 140 with respect to cycle change of the plurality of battery cells 110, 120, 130, and 140.

The controller 220 may predict the capacity of the plurality of battery cells 110, 120, 130, and 140 based on comparison data and capacity change data. More specifically, the controller 220 may predict capacity change of the plurality of battery cells 110, 120, 130, and 140 under reference performance test conditions based on capacity change data and a comparison value.

The controller 220 may multiply a reciprocal ( $\dfrac{C_{RPT}}{C}$ ) of the comparison value to the capacity deterioration amount defined per cycle ($\Delta C$) of the plurality of battery cells 110, 120, 130, and 140 to calculate $\Delta C \times \dfrac{C_{RPT}}{C}$ as a capacity change rate of the plurality of battery cells 110, 120, 130, and 140 under reference performance test conditions.

The controller 220 may convert a reference capacity of the plurality of battery cells into a nominal capacity of the plurality of battery cells based on the predicted capacity of the plurality of battery cells 110, 120, 130, and 140 under the reference performance test conditions to predict the capacity of the plurality of battery cells under full equivalent cycle (FEC) conditions.

The controller 220 may multiply a value ($C_{nominal}/C$) obtained by comparing the nominal capacity ($C_{nominal}$) of the battery cells 110, 120, 130, and 140 with the measured capacity C of the plurality of battery cells 110, 120, 130, and 140 to the capacity deterioration amount per cycle ($\Delta C$) of the plurality of battery cells 110, 120, 130, and 140 under the reference performance test conditions to calculate the capacity deterioration amount (($\Delta C)_{FEC}$) of the plurality of battery cells 110, 120, 130, and 140 under the FEC conditions.

$$(\Delta C)_{FEC} = (C_n - C_{n-k}) \times \frac{C_{nominal}}{C} / k = \Delta C \times \frac{C_{nominal}}{C} / k$$

Herein, the controller 220 may select a multiple of the value k to increase a value of the small capacity deterioration amount (($\Delta C)_{FEC}$) of the plurality of battery cells 110, 120, 130, and 140.

The controller 220 may extract the capacity change pattern of the battery based on the capacity of the battery under the full equivalent cycle conditions.

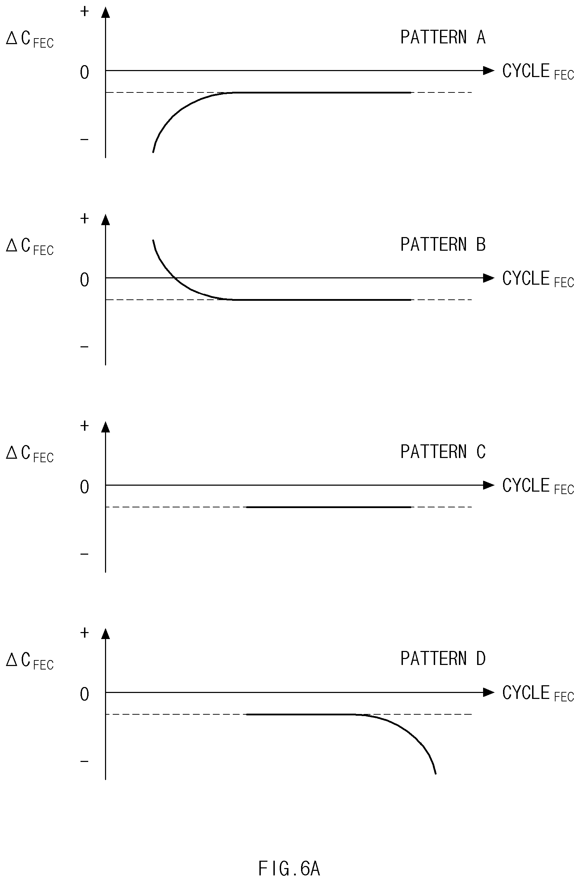

FIG. 6A is a graph showing a capacity change pattern of a battery with respect to a full equivalent cycle change of the battery, according to an embodiment disclosed herein. Referring to FIG. 6A, more specifically, the controller 220 may calculate a graph showing change in capacity deterioration amount ($\Delta C_{FEC}$) of the plurality of battery cells 110, 120, 130, and 140 under the FEC conditions.

The controller 220 may extract and analyze a pattern A, a pattern B, a pattern C, and a pattern D that are various capacity change patterns of the plurality of battery cells 110, 120, 130, and 140.

In FIG. 6A, the pattern A calculated by the controller 220, which is a pattern appearing when the deterioration speed of the plurality of battery cells 110, 120, 130, and 140 decreases, may appear in a battery cycle immediately after the reference performance test of the plurality of battery cells 110, 120, 130, and 140. The controller 220 may analyze the pattern A as a capacity change pattern appearing as temperatures or currents of the plurality of battery cells 110, 120, 130, and 140 are different.

In FIG. 6A, the pattern A calculated by the controller 220 may be analyzed as a pattern appearing when the deterioration speed of the plurality of battery cells 110, 120, 130, and 140 is constant. The controller 220 may analyze the pattern C as a capacity change pattern appearing when a loss of an active material (LAM) of the plurality of battery cells 110, 120, 130, and 140 linearly deteriorates.

In FIG. 6A, the pattern D calculated by the controller 220 may be analyzed as a pattern appearing when the deterioration speed of the plurality of battery cells 110, 120, 130, and 140 is accelerated. The controller 220 may analyze the pattern D as a pattern appearing when the capacity of the plurality of battery cells 110, 120, 130, and 140 exponentially decreases due to lithium plating or rapid reduction of an electrolyte of the plurality of battery cells 110, 120, 130, and 140.

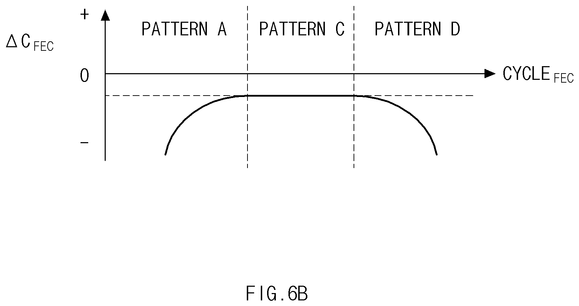

FIG. 6B is a graph showing a capacity change of a battery with respect to a full equivalent cycle change of the battery, according to an embodiment disclosed herein. The controller 220 may extract a graph showing a capacity change of a battery with respect to a full equivalent cycle change of the battery by collecting various capacity change patterns of the battery with respect to a full equivalent cycle change of the battery shown in FIG. 6A.

The controller 220 may analyze a capacity change pattern of the plurality of battery cells 110, 120, 130, and 140 immediately after a reference performance test, a normal capacity change pattern of the plurality of battery cells 110, 120, 130, and 140, and a rapid capacity deterioration pattern of the plurality of battery cells 110, 120, 130, and 140, based on FIG. 6B.

As described above, with the battery capacity prediction apparatus 200 according to an embodiment disclosed herein, a capacity decrease of a battery in various temperature, current, and voltage sections may be analyzed to diagnose a rapid capacity decrease of the battery in advance.

In addition, the battery capacity prediction apparatus 200 may improve the efficiency and stability of battery management by accurately diagnosing rapid deterioration of the capacity of the battery in advance. Moreover, the battery capacity prediction apparatus 200 may define a relationship between the reference capacity of the battery measured through a reference performance test and a deterioration cycle of the battery to extract a capacity change pattern of the battery.

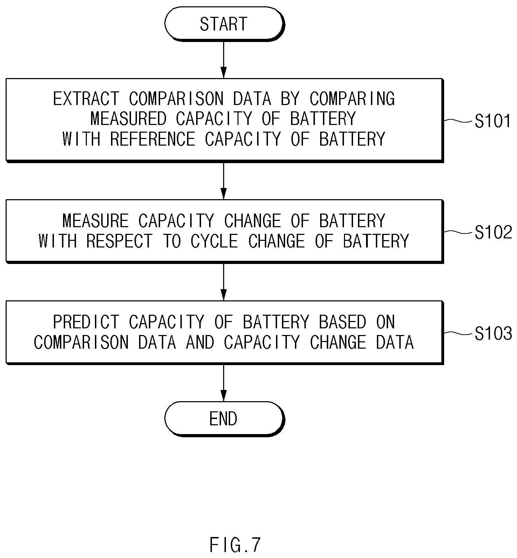

FIG. 7 is a flowchart of an operating method of a battery capacity prediction apparatus according to an embodiment disclosed herein.

Hereinbelow, referring to FIGS. 1 to 6, an operating method of the battery capacity prediction apparatus 200 will be described.

The battery capacity prediction apparatus 200 may be substantially the same as the battery capacity prediction apparatus 200 described with reference to FIGS. 1 to 6, and thus will be briefly described to avoid redundant description.

Referring to FIG. 7, an operating method of the battery capacity prediction apparatus 200 may include operation S101 of comparing a measured capacity of a battery with a reference capacity of the battery to extract comparison data, operation S102 of measuring a capacity change of the battery with respect to a cycle change of the battery, and operation S103 of predicting a capacity of the battery based on the comparison data and capacity change data.

In operation S101, the extraction unit 210 may obtain reference capacity data ($C_{RPT}$) obtained by measuring a reference capacity of the plurality of battery cells 110, 120, 130, and 140. Herein, a reference capacity may refer to a capacity of a battery, measured through an RPT. The reference performance test may periodically measure a life or a capacity of a battery under specific temperature, specific current, and specific voltage range conditions to identify deteriorating performance of the target device. According to an embodiment, the reference performance test may repeat charge and discharge under specific temperature and specific current conditions until the battery reaches a voltage with an SoC of 100 % from a voltage with an SoC of 0 %.

In operation S101, the extraction unit 210 may compare reference capacity data ($C_{RPT}$) of the plurality of battery cells 110, 120, 130, and 140 with measured capacity data C of the plurality of battery cells 110, 120, 130, and 140 to extract comparison data of comparing a measured capacity C of the plurality of battery cells 110, 120, 130, and 140 with a reference capacity ($C_{RPT}$) of the plurality of battery cells 110, 120, 130, and 140.

In operation S101, more specifically, the extraction unit 210 may extract a comparison value ($\frac{C}{C_{RPT}}$) of comparing the measured capacity C of the plurality of battery cells 110, 120, 130, and 140 with the reference capacity ($C_{RPT}$) of the plurality of battery cells 110, 120, 130, and 140.

In operation S101, the extraction unit 120 may generate a graph showing comparison value change with respect to temperature change of the plurality of battery cells 110, 120, 130, and 140. In operation S101, the extraction unit 120 may generate a graph showing change in comparison value ($\frac{C}{C_{RPT}}$) with respect to current change of the plurality of battery cells 110, 120, 130, and 140. In operation S101, the extraction unit 210 may analyze change in comparison value ($\frac{C}{C_{RPT}}$) with respect to temperature change of the plurality of battery cells 110, 120, 130, and 140 or current change of the plurality of battery cells 110, 120, 130, and 140 to measure a trend of change in comparison value ($\frac{C}{C_{RPT}}$ with respect to temperature change of the plurality of battery cells 110, 120, 130, and 140 or a trend of change in comparison value ($\frac{C}{C_{RPT}}$) with respect to current change of the battery.

In operation S102, the extraction unit 210 may measure a capacity change amount per cycle of the plurality of battery cells 110, 120, 130, and 140 with respect to cycle change of the plurality of battery cells 110, 120, 130, and 140. In operation S102, the extraction unit 210 may measure a capacity deterioration amount per cycle ($\Delta C$) of the plurality of battery cells 110, 120, 130, and 140 with respect to cycle change of the plurality of battery cells 110, 120, 130, and 140.

In operation S103, the controller 220 may predict the capacity of the plurality of battery cells 110, 120, 130, and 140 based on comparison data and capacity change data. In operation S103, the controller 220 may predict capacity change of the plurality of battery cells 110, 120, 130, and 140 under reference performance test conditions based on capacity change data and a comparison value.

In operation S103, the controller 220 may multiply a reciprocal ( $\frac{C_{RPT}}{C}$ ) of the comparison value to the capacity deterioration amount per cycle ($\Delta C$) of the plurality of battery cells 110, 120, 130, and 140 to calculate $\Delta C \times \frac{C_{RPT}}{C}$ as a capacity change rate of the plurality of battery cells 110, 120, 130, and 140 under reference performance test conditions.

In operation S103, the controller 220 may convert a reference capacity of the plurality of battery cells into a nominal capacity of the plurality of battery cells based on the predicted capacity of the plurality of battery cells 110, 120, 130, and 140 under the reference performance test conditions to predict the capacity of the plurality of battery cells under the FEC conditions.

In operation S103, the controller 220 may multiply a value $C_{nominal}/C$ obtained by comparing the nominal capacity ($C_{nominal}$) of the battery cells 110, 120, 130, and 140 with the measured capacity C of the plurality of battery cells 110, 120, 130, and 140 to the capacity deterioration amount per cycle ($\Delta C$) of the plurality of battery cells 110, 120, 130, and 140 under the reference performance test conditions to calculate the capacity deterioration amount (($\Delta C$) $_{FEC}$) of the plurality of battery cells 110, 120, 130, and 140 under the FEC conditions.

In operation S103, the controller 220 may extract the capacity change pattern of the battery based on the capacity of the battery under the full equivalent cycle conditions.

In operation S103, the controller 220 may extract a graph showing a capacity change of a battery with respect to a full equivalent cycle change of the battery by collecting capacity change patterns of the battery with respect to a full equivalent cycle change of the battery.

In operation S103, the controller 220 may analyze a capacity change pattern of the plurality of battery cells 110, 120, 130, and 140 immediately after a reference performance test, a normal capacity change pattern of the plurality of battery cells 110, 120, 130, and 140, and a rapid capacity deterioration pattern of the plurality of battery cells 110, 120, 130, and 140.

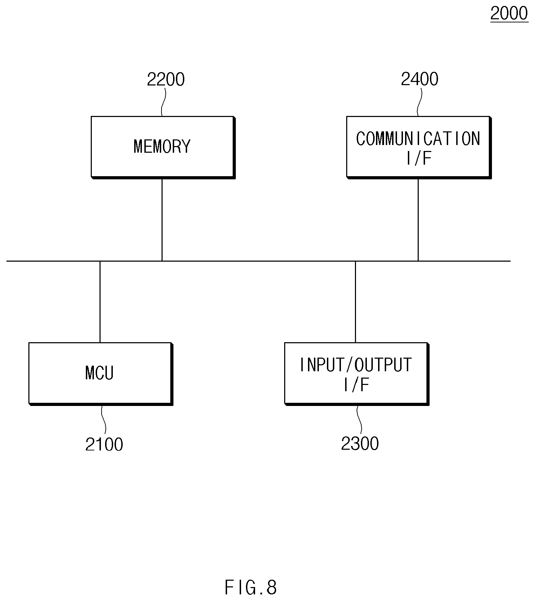

FIG. 8 is a block diagram showing a hardware configuration of a computing system for implementing a battery capacity prediction apparatus according to an embodiment disclosed herein.

Referring to FIG. 8, a computing system 2000 according to an embodiment disclosed herein may include an MCU 2100, a memory 2200, an input/output I/F 2300, and a communication I/F 2400.

The MCU 2100 may be a processor that executes various programs (e.g., a battery capacity prediction function, etc.) stored in the memory 2200, processes various data through these programs, and perform the above-described functions of the battery capacity prediction apparatus 200 shown in FIG. 1.

The memory 2200 may store various programs regarding operations of the battery capacity prediction apparatus . Moreover, the memory 2200 may store operation data of the battery capacity prediction apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

As such, a computer program according to an embodiment disclosed herein may be recorded in the memory 2200 and processed by the MCU 2100, thus being implemented as a module that performs respective functions of the battery capacity prediction apparatus 200 shown in FIGS. 1 and 2.

The scope of the invention is defined by the appended claims.

**Claims**

**1.** A battery capacity prediction apparatus (200) comprising:

an extraction unit (210) configured to extract comparison data obtained by comparing a measured capacity of a battery (110, 120, 130, 140) with a reference capacity of the battery (110, 120, 130, 140) and extract capacity change data obtained by measuring a capacity change of the battery (110, 120, 130, 140) with respect to a cycle change of the battery (110, 120, 130, 140); and

a controller (220) configured to predict a capacity of the battery (110, 120, 130, 140) based on the comparison data and the capacity change data;

wherein the extraction unit (210) is further configured to extract a comparison value ( $\frac{C}{C_{RPT}}$ ) obtained by comparing the measured capacity of the battery (110, 120, 130, 140) with the reference capacity of the battery (110, 120, 130, 140), measured through a reference performance test (RPT);

**characterized in that** the controller (220) is further configured to multiply a reciprocal of the comparison value ( $\frac{C}{C_{RPT}}$ ) to a capacity deterioration amount per cycle ($\Delta$C) of the plurality of battery cells (110, 120, 130, 140), the capacity deterioration amount per cycle ($\Delta$C) being the difference between a capacity ($C_n$) for n cycle repetitions of the plurality of battery cells (110, 120, 130, 140) and a capacity ($C_{n-k}$) of the plurality of battery cells (110, 120, 130, 140) before k cycles, k being less than n, thus obtaining said capacity change data.

2. The battery capacity prediction apparatus of claim 1, wherein the extraction unit (210) is further configured to measure a change of the comparison value with respect to a temperature change of the battery or a change of the comparison value with respect to a current change of the battery.

3. The battery capacity prediction apparatus of claim 1, wherein the controller (220) is further configured to predict the capacity of the battery (110, 120, 130, 140) under full equivalent cycle (FEC) conditions by converting the reference capacity into a nominal capacity of the battery.

4. The battery capacity prediction apparatus of claim 3, wherein the controller (220) is further configured to extract a capacity change pattern of the battery (110, 120, 130, 140) based on the capacity of the battery under the full equivalent cycle (FEC) conditions.

5. The battery capacity prediction apparatus of claim 4, wherein the controller (220) is further configured to analyze a capacity change pattern immediately after the reference performance test, a normal capacity change pattern, and a rapid capacity deterioration pattern by extracting the capacity change pattern of the battery (110, 120, 130, 140).

6. An operating method of a battery capacity prediction apparatus (200), the operating method comprising:

extracting (S101) comparison data by comparing a measured capacity of a battery (110, 120, 130, 140) with a reference capacity of the battery (110, 120, 130, 140);
measuring (S102) capacity change data of the battery (110, 120, 130, 140) with respect to a cycle change of the battery (110, 120, 130, 140); and
predicting (S103) a capacity of the battery (110, 120, 130, 140) based on the comparison data and the capacity change data;
wherein the extracting (S101) of the comparison data by comparing the measured capacity of the battery (110, 120, 130, 140) with the reference capacity of the battery (110, 120, 130, 140) comprises extracting a comparison value ( $\frac{C}{C_{RPT}}$ ) obtained by comparing the measured capacity of the battery (110, 120, 130, 140) with the reference capacity of the battery (110, 120, 130, 140), measured through a reference performance test (RPT),

**characterized in that** the method further comprises multiplying a reciprocal of the comparison value ( $\frac{C}{C_{RPT}}$ ) to a capacity deterioration amount per cycle ($\Delta$C) of the plurality of battery cells (110, 120, 130, 140), the capacity deterioration amount per cycle ($\Delta$C) being the difference between a capacity ($C_n$) for n cycle repetitions of the plurality of battery cells (110, 120, 130, 140) and a capacity ($C_{n-k}$) of the plurality of battery cells (110, 120, 130, 140) before k cycles, k being less than n, thus obtaining said capacity change data.

7. The operating method of claim 6, wherein the extracting (S101) of the comparison data by comparing the measured capacity of the battery (110, 120, 130, 140) with the reference capacity of the battery (110, 120, 130, 140) comprises measuring a change of the comparison value with respect to a temperature change of the battery (110, 120, 130, 140) or a change of the comparison value with respect to a current change of the battery (110, 120, 130, 140).

8. The operating method of claim 7, wherein the predicting (S103) of the capacity of the battery (110, 120, 130, 140) based on the comparison data and the capacity change data comprises predicting a capacity of the battery (110, 120, 130, 140) under reference performance test conditions based on the capacity change data and the comparison value.

9. The operating method of claim 6, wherein the predicting (S103) of the capacity of the battery (110, 120, 130, 140) based on the comparison data and the capacity change data comprises predicting the capacity of the battery (110, 120, 130, 140) under full equivalent cycle (FEC) conditions by converting the reference capacity into a nominal capacity of the battery (110, 120, 130, 140).

10. The operating method of claim 9, wherein the predicting (S103) of the capacity of the battery (110, 120, 130, 140) based on the comparison data and the capacity change data comprises extracting a capacity change pattern of the battery (110, 120, 130, 140) based on the capacity of the battery (110, 120, 130, 140) under the full equivalent cycle conditions.

11. The operating method of claim 10, wherein the predicting (S103) of the capacity of the battery (110, 120, 130, 140) based on the comparison data and the capacity change data comprises analyzing a capacity change pattern immediately after the reference performance test, a normal capacity change pattern, and a rapid capacity deterioration pattern by extracting the capacity change pattern of the battery (110, 120, 130, 140).

**Patentansprüche**

1. Batteriekapazitätsvorhersagevorrichtung (200), umfassend:

eine Extraktionseinheit (210), welche dazu eingerichtet ist, Vergleichsdaten zu extrahieren, welche durch ein Vergleichen einer gemessenen Kapazität einer Batterie (110, 120, 130, 140) mit einer Referenzkapazität der Batterie (110, 120, 130, 140) erhalten worden sind, und Kapazitätsänderungsdaten zu extrahieren, welche durch Messen einer Kapazitätsänderung der Batterie (110, 120, 130, 140) in Bezug auf eine Zyklusänderung der Batterie (110, 120, 130, 140) erhalten worden sind; und
eine Steuerung (220), welche dazu eingerichtet ist, eine Kapazität der Batterie (110, 120, 130, 140) basierend auf den Vergleichsdaten und den Kapazitätsänderungsdaten vorherzusagen;

wobei die Extraktionseinheit (210) ferner dazu eingerichtet ist, einen Vergleichswert ( $\frac{C}{C_{RPT}}$ ) zu extrahieren, welcher durch ein Vergleichen der gemessenen Kapazität der Batterie (110, 120, 130, 140) mit der Referenzkapazität der Batterie (110, 120, 130, 140) erhalten worden ist, welche durch einen Referenzleistungstest (RPT) gemessen worden ist;

**dadurch gekennzeichnet, dass** die Steuerung (220) ferner dazu eingerichtet ist, einen Kehrwert des Vergleichswertes ( $\frac{C}{C_{RPT}}$ ) mit einem Kapazitätsverschlechterungsumfang pro Zyklus ($\Delta$C) der Mehrzahl von Batteriezellen (110, 120, 130, 140) zu multiplizieren, wobei der Kapazitätsverschlechterungsumfang pro Zyklus ($\Delta$C) die Differenz zwischen einer Kapazität ($C_n$) für n Zykluswiederholungen der Mehrzahl von Batteriezellen (110, 120, 130, 140) und einer Kapazität ($C_{n-k}$) der Mehrzahl von Batteriezellen (110, 120, 130, 140) vor k Zyklen ist, wobei k kleiner als n ist, sodass die Kapazitätsänderungsdaten erlangt werden.

2. Batteriekapazitätsvorhersagevorrichtung nach Anspruch 1, wobei die Extraktionseinheit (210) ferner dazu eingerichtet ist, eine Änderung des Vergleichswertes in Bezug auf eine Temperaturänderung der Batterie oder eine Änderung des Vergleichswertes in Bezug auf eine Stromänderung der Batterie zu messen.

3. Batteriekapazitätsvorhersagevorrichtung nach Anspruch 1, wobei die Steuerung (220) ferner dazu eingerichtet ist, die Kapazität der Batterie (110, 120, 130, 140) unter Bedingungen eines vollen äquivalenten Zyklus (FEC) durch Konvertieren der Referenzkapazität in eine nominale Kapazität der Batterie vorherzusagen.

4. Batteriekapazitätsvorhersagevorrichtung nach Anspruch 3, wobei die Steuerung (220) ferner dazu eingerichtet ist, ein Kapazitätsänderungsmuster der Batterie (110, 120, 130, 140) basierend auf der Kapazität der Batterie unter den Bedingungen eines vollen äquivalenten Zyklus (FEC) zu extrahieren.

5. Batteriekapazitätsvorhersagevorrichtung nach Anspruch 4, wobei die Steuerung (220) ferner dazu eingerichtet ist, ein Kapazitätsänderungsmuster umgehend nach dem Referenzleistungstest, ein normales Kapazitätsänderungsmuster und ein schnelles Kapazitätsverschlechterungsmuster durch Extrahieren des Kapazitätsänderungsmusters der Batterie (110, 120, 130, 140) zu analysieren.

6. Betriebsverfahren einer Batteriekapazitätsvorhersagevorrichtung (200), wobei das Betriebsverfahren umfasst:

Extrahieren (S101) von Vergleichsdaten durch ein Vergleichen einer gemessenen Kapazität einer Batterie (110, 120, 130, 140) mit einer Referenzkapazität der Batterie (110, 120, 130, 140);
Messen (S102) von Kapazitätsänderungsdaten der Batterie (110, 120, 130, 140) in Bezug auf eine Zyklusänderung der Batterie (110, 120, 130, 140); und
Vorhersagen (S103) einer Kapazität der Batterie (110, 120, 130, 140) basierend auf den Vergleichsdaten und den Kapazitätsänderungsdaten;
wobei das Extrahieren (S101) der Vergleichsdaten durch ein Vergleichen der gemessenen Kapazität der Batterie (110, 120, 130, 140) mit der Referenzkapazität der Batterie (110, 120, 130, 140) ein Extrahieren eines Vergleichswertes ( $\frac{C}{C_{RPT}}$ ) umfasst, welcher durch Vergleichen der gemessenen Kapazität der Batterie (110, 120, 130, 140) mit der Referenzkapazität der Batterie (110, 120, 130, 140) erhalten wird, welche durch einen Referenzleistungstest (RPT) gemessen wird, **dadurch gekennzeichnet, dass** das Verfahren ferner ein Multiplizieren eines Kehrwertes des Vergleichswertes ( $\frac{C}{C_{RPT}}$ ) mit einem Kapazitätsverschlechterungsumfang pro Zyklus ($\Delta C$) der Mehrzahl von Batteriezellen (110, 120, 130, 140) umfasst, wobei der Kapazitätsverschlechterungsumfang pro Zyklus ($\Delta C$) die Differenz zwischen einer Kapazität ($C_n$) für n Zykluswiederholungen der Mehrzahl von Batteriezellen (110, 120, 130, 140) und einer Kapazität ($C_{n-k}$) der Mehrzahl von Batteriezellen (110, 120, 130, 140) vor k Zyklen ist, wobei k kleiner als n ist, sodass die Kapazitätsänderungsdaten erlangt werden.

7. Betriebsverfahren nach Anspruch 6, wobei das Extrahieren (S101) der Vergleichsdaten durch ein Vergleichen der gemessenen Kapazität der Batterie (110, 120, 130, 140) mit der Referenzkapazität der Batterie (110, 120, 130, 140) ein Messen einer Änderung des Vergleichswertes in Bezug auf eine Temperaturänderung der Batterie (110, 120, 130, 140) oder einer Änderung des Vergleichswertes in Bezug auf eine Stromänderung der Batterie (110, 120, 130, 140) umfasst.

8. Betriebsverfahren nach Anspruch 7, wobei das Vorhersagen (S103) der Kapazität der Batterie (110, 120, 130, 140) basierend auf den Vergleichsdaten und den Kapazitätsänderungsdaten ein Vorhersagen einer Kapazität der Batterie (110, 120, 130, 140) unter Bedingungen eines Referenzleistungstests basierend auf den Kapazitätsänderungsdaten und dem Vergleichswert umfasst.

9. Betriebsverfahren nach Anspruch 6, wobei das Vorhersagen (S103) der Kapazität der Batterie (110, 120, 130, 140) basierend auf den Vergleichsdaten und den Kapazitätsänderungsdaten ein Vorhersagen der Kapazität der Batterie (110, 120, 130, 140) unter Bedingungen eines vollen äquivalenten Zyklus (FEC) durch Konvertieren der Referenzkapazität in eine nominale Kapazität der Batterie (110, 120, 130, 140) umfasst.

10. Betriebsverfahren nach Anspruch 9, wobei das Vorhersagen (S103) der Kapazität der Batterie (110, 120, 130, 140) basierend auf den Vergleichsdaten und den Kapazitätsänderungsdaten ein Extrahieren eines Kapazitätsänderungsmusters der Batterie (110, 120, 130, 140) basierend auf der Kapazität der Batterie (110, 120, 130, 140) unter den Bedingungen eines vollen äquivalenten Zyklus umfasst.

11. Betriebsverfahren nach Anspruch 10, wobei das Vorhersagen (S103) der Kapazität der Batterie (110, 120, 130, 140) basierend auf den Vergleichsdaten und den Kapazitätsänderungsdaten ein Analysieren eines Kapazitätsänderungsmusters umgehend nach dem Referenzleistungstest, eines normalen Kapazitätsänderungsmusters und eines schnellen Kapazitätsverschlechterungsmusters durch Extrahieren des Kapazitätsänderungsmusters der Batterie (110, 120, 130, 140) umfasst.

**Revendications**

1. Appareil de prédiction de capacité de batterie (200) comprenant :

une unité d'extraction (210) configurée pour extraire des données de comparaison obtenues par la comparaison d'une capacité mesurée d'une batterie (110, 120, 130, 140) avec une capacité de référence de la batterie (110, 120, 130, 140) et extraire des données de changement de capacité obtenues par la mesure d'un changement de capacité de la batterie (110, 120, 130, 140) par rapport à un changement de cycle de la batterie (110, 120, 130, 140) ; et

un dispositif de commande (220) configuré pour prédire une capacité de la batterie (110, 120, 130, 140) sur la base des données de comparaison et des données de changement de capacité ;

dans lequel l'unité d'extraction (210) est en outre configurée pour extraire une valeur de comparaison ( $\frac{C}{C_{RPT}}$ )

obtenue par la comparaison de la capacité mesurée de la batterie (110, 120, 130, 140) avec la capacité de référence de la batterie (110, 120, 130, 140), mesurée par le biais d'un test de performances de référence (RPT) ; **caractérisé en ce que** le dispositif de commande (220) est en outre configuré pour multiplier une réciproque de la valeur de comparaison ( $\frac{C}{C_{RPT}}$ ) par une quantité de détérioration de capacité par cycle (ΔC) de la pluralité d'éléments de batterie (110, 120, 130, 140), la quantité de détérioration de capacité par cycle (ΔC) étant la différence entre une capacité ($C_n$) pour n répétitions de cycle de la pluralité d'éléments de batterie (110, 120, 130, 140) et une capacité ($C_{n-k}$) de la pluralité d'éléments de batterie (110, 120, 130, 140) avant k cycles, k étant inférieur à n, en obtenant ainsi lesdites données de changement de capacité.

2. Appareil de prédiction de capacité de batterie selon la revendication 1, dans lequel l'unité d'extraction (210) est en outre configurée pour mesurer un changement de la valeur de comparaison par rapport à un changement de température de la batterie ou un changement de la valeur de comparaison par rapport à un changement de courant de la batterie.

3. Appareil de prédiction de capacité de batterie selon la revendication 1, dans lequel le dispositif de commande (220) est en outre configuré pour prédire la capacité de la batterie (110, 120, 130, 140) dans des conditions de cycle équivalent complet (FEC) par la conversion de la capacité de référence en une capacité nominale de la batterie.

4. Appareil de prédiction de capacité de batterie selon la revendication 3, dans lequel le dispositif de commande (220) est en outre configuré pour extraire un profil de changement de capacité de la batterie (110, 120, 130, 140) sur la base de la capacité de la batterie dans les conditions de cycle équivalent complet (FEC).

5. Appareil de prédiction de capacité de batterie selon la revendication 4, dans lequel le dispositif de commande (220) est en outre configuré pour analyser un profil de changement de capacité immédiatement après le test de performances de référence, un profil de changement de capacité normal et un profil de détérioration de capacité rapide par l'extraction du profil de changement de capacité de la batterie (110, 120, 130, 140).

6. Procédé de fonctionnement d'un appareil de prédiction de capacité de batterie (200), le procédé de fonctionnement comprenant :

l'extraction (S101) de données de comparaison par la comparaison d'une capacité mesurée d'une batterie (110, 120, 130, 140) avec une capacité de référence de la batterie (110, 120, 130, 140) ;
la mesure (S102) de données de changement de capacité de la batterie (110, 120, 130, 140) par rapport à un changement de cycle de la batterie (110, 120, 130, 140) ; et
la prédiction (S103) d'une capacité de la batterie (110, 120, 130, 140) sur la base des données de comparaison et des données de changement de capacité ;
dans lequel l'extraction (S101) des données de comparaison par la comparaison de la capacité mesurée de la batterie (110, 120, 130, 140) avec la capacité de référence de la batterie (110, 120, 130, 140) comprend l'extraction d'une valeur de comparaison ( $\frac{C}{C_{RPT}}$ ) obtenue par la comparaison de la capacité mesurée de la batterie (110, 120, 130, 140) avec la capacité de référence de la batterie (110, 120, 130, 140), mesurée par le biais d'un test de performances de référence (RPT),

**caractérisé en ce que** le procédé comprend en outre la multiplication d'une réciproque de la valeur de comparaison ( $\frac{C}{C_{RPT}}$ ) par une quantité de détérioration de capacité par cycle ($\Delta C$) de la pluralité d'éléments de batterie (110, 120, 130, 140), la quantité de détérioration de capacité par cycle ($\Delta C$) étant la différence entre une capacité ($C_n$) pour n répétitions de cycle de la pluralité d'éléments de batterie (110, 120, 130, 140) et une capacité ($C_{n-k}$) de la pluralité d'éléments de batterie (110, 120, 130, 140) avant k cycles, k étant inférieur à n, en obtenant ainsi lesdites données de changement de capacité.

7. Procédé de fonctionnement selon la revendication 6, dans lequel l'extraction (S101) des données de comparaison par la comparaison de la capacité mesurée de la batterie (110, 120, 130, 140) avec la capacité de référence de la batterie (110, 120, 130, 140) comprend la mesure d'un changement de la valeur de comparaison par rapport à un changement de température de la batterie (110, 120, 130, 140) ou d'un changement de la valeur de comparaison par rapport à un changement de courant de la batterie (110, 120, 130, 140).

8. Procédé de fonctionnement selon la revendication 7, dans lequel la prédiction (S103) de la capacité de la batterie (110, 120, 130, 140) sur la base des données de comparaison et des données de changement de capacité comprend la prédiction d'une capacité de la batterie (110, 120, 130, 140) dans des conditions de test de performances de référence sur la base des données de changement de capacité et de la valeur de comparaison.

9. Procédé de fonctionnement selon la revendication 6, dans lequel la prédiction (S103) de la capacité de la batterie (110, 120, 130, 140) sur la base des données de comparaison et des données de changement de capacité comprend la prédiction de la capacité de la batterie (110, 120, 130, 140) dans des conditions de cycle équivalent complet (FEC) par la conversion de la capacité de référence en une capacité nominale de la batterie (110, 120, 130, 140).

10. Procédé de fonctionnement selon la revendication 9, dans lequel la prédiction (S103) de la capacité de la batterie (110, 120, 130, 140) sur la base des données de comparaison et des données de changement de capacité comprend l'extraction d'un profil de changement de capacité de la batterie (110, 120, 130, 140) sur la base de la capacité de la batterie (110, 120, 130, 140) dans les conditions de cycle équivalent complet.

11. Procédé de fonctionnement selon la revendication 10, dans lequel la prédiction (S103) de la capacité de la batterie (110, 120, 130, 140) sur la base des données de comparaison et des données de changement de capacité comprend l'analyse d'un profil de changement de capacité immédiatement après le test de performances de référence, d'un profil de changement de capacité normal et d'un profil de détérioration de capacité rapide par l'extraction du profil de changement de capacité de la batterie (110, 120, 130, 140).

FIG.1

200

```
┌─────────────────┐        ┌─────────────────┐
│   EXTRACTION    │        │   CONTROLLER    │
│      UNIT       │────────│                 │
│      210        │        │      220        │
└─────────────────┘        └─────────────────┘
```

FIG.2

FIG.3

FIG.4A

FIG.4B

FIG.5

FIG.6A

FIG.6B

START

EXTRACT COMPARISON DATA BY COMPARING
MEASURED CAPACITY OF BATTERY
WITH REFERENCE CAPACITY OF BATTERY — S101

MEASURE CAPACITY CHANGE OF BATTERY
WITH RESPECT TO CYCLE CHANGE OF BATTERY — S102

PREDICT CAPACITY OF BATTERY BASED ON
COMPARISON DATA AND CAPACITY CHANGE DATA — S103

END

FIG.7

2000

2200

MEMORY

2400

COMMUNICATION
I/F

MCU

INPUT/OUTPUT
I/F

2100

2300

FIG.8

**REFERENCES CITED IN THE DESCRIPTION**

**Patent documents cited in the description**

- KR 1020220003018
- US 20200386819 A